# EUROPÄISCHE PATENTANMELDUNG

(11) **EP 3 657 920 A1**
(43) Veröffentlichungstag der Anmeldung: **27.05.2020**
(21) Anmeldenummer: 19207785.7
(22) Anmeldetag: 07.11.2019
(51) Int. Cl.: H05K 7/14

(54) **GEHÄUSE ZUR AUFNAHME VON MINDESTENS EINER ELEKTROMECHANISCHEN, ELEKTRISCHEN UND/ODER ELEKTRONISCHEN KOMPONENTE**

(30) Priorität: 26.11.2018 DE 202018106719 U
(71) Anmelder: Weidmüller Interface GmbH & Co. KG, 32758 Detmold (DE)
(72) Erfinder: TRAPP, Ulrich, 32756 Detmold (DE); SCHUMACHER, Ralf, 32657 Lemgo (DE); BEERMANN, Mike, 32760 Detmold (DE); WENDT, Niklas, 33189 Schlangen (DE)
(74) Vertreter: Kleine, Hubertus

(57) **Zusammenfassung**

Gehäuse zur Aufnahme von mindestens einer elektromechanischen, elektrischen und/oder elektronischen Komponente, aufweisend mindestens ein an einem Gehäuseteil angeordnetes Befestigungselement (10) für die Komponente, wobei in dem Gehäuseteil eine Vertiefung (11) ausgebildet ist, in der das mindestens eine Befestigungselement (10) angeordnet ist.

## Beschreibung

Die Erfindung betrifft ein Gehäuse zur Aufnahme von mindestens einer elektromechanischen, elektrischen und/oder elektronischen Komponente, beispielsweise einer Leiterplatte oder eines Tragschienenabschnitts, wobei das Gehäuse mindestens ein an einem Gehäuseteil angeordnetes Befestigungselement für die Komponente aufweist.

Derartige Gehäuse, insbesondere in Form von Kleingehäusen mit einem Innenvolumen von weniger als einem oder einigen Litern, werden im industriellen Bereich häufig zur Aufnahme von elektromechanischen, elektrischen und/oder elektronischen Komponenten insbesondere in einer Feldverteilung, also abseits von zentralen Schaltschränken eingesetzt.

Häufig sind die Gehäuse mehrteilig, insbesondere zweiteilig aufgebaut, mit einem Gehäusegrundteil und einem verschließenden Deckel. Im Gehäusegrundteil sind in der Regel Befestigungselemente vorhanden, die einer Befestigung der aufgenommenen Komponenten dienen. Solche Befestigungselemente können beispielsweise (Rund-) Sockel sein, die als Abstandshalter und Auflagepunkte für die Komponenten dienen, Einschraubdome zur Schraubbefestigung der Komponenten oder Rastelemente, beispielsweise Rastlaschen oder Haken, für eine rastende Befestigung der Komponenten.

Je nach Anwendungsfall können Befestigungselemente dabei jedoch nicht nur nicht benötigt werden, sondern auch störend sein, wenn sie Platz beanspruchen, den die aufzunehmenden Komponenten benötigen. In der Regel ist das Gehäuse aus einem Kunststoff gefertigt, der dann ein Herausbrechen der Befestigungselemente, beispielsweise mit Hilfe einer Greifzange, ermöglicht. Dabei kann jedoch das Problem auftreten, dass die Befestigungselemente nicht glatt und bündig mit einer Gehäusefläche abbrechen, sondern mit Bruchresten, beispielsweise Bruchkanten, über diese Gehäusefläche hinaus abstehen. In diesem Bereich der Gehäusefläche ist dann ein flächenbündiges Montieren von Komponenten verhindert.

Es ist Aufgabe der vorliegenden Erfindung, ein Gehäuse der eingangs genannten Art zu schaffen, bei dem Befestigungselemente herausgebrochen werden können, ohne dass Bruchreste verbleiben, die eine flächenbündige Montage von Komponenten verhindern.

Diese Aufgabe wird durch ein Gehäuse mit den Merkmalen des unabhängigen Anspruchs gelöst. Vorteilhafte Ausgestaltungen und Weiterbildungen sind in den abhängigen Ansprüchen angegeben.

Ein erfindungsgemäßes Gehäuse der eingangs genannten Art zeichnet sich dadurch aus, dass in dem Gehäuseteil eine Vertiefung ausgebildet ist, in der das mindestens eine Befestigungselement angeordnet ist. Die Vertiefung ist somit um das mindestens eine Befestigungselement herum ausgebildet. Beim Herausbrechen des Befestigungselements steht eine Bruchkante dann ggf. über eine Grundfläche der Vertiefung hervor, nicht jedoch über die Oberfläche des Gehäuseteils, so dass Komponenten auf dieser Fläche flächenbündig montiert werden können.

In einer vorteilhaften Ausgestaltung des Gehäuses ist das mindestens eine Befestigungselement an einem Boden eines Gehäusegrundteils angeordnet. Derartige Gehäuse mit einem Gehäusegrundteil, das in der Regel von einem Deckel verschließbar ist und bei dem die aufgenommen Komponenten an dem Gehäusegrundteil befestigt sind, werden vielfältig eingesetzt. Es versteht sich aber, dass die anmeldungsgemäße Vertiefung auch an anderen Gehäuseteilen, z.B. dem genannten Deckel, oder an anderer Stelle am Gehäusegrundteil, z.B. an einer Seitenwand, umgesetzt sein kann.

In einer weiteren vorteilhaften Ausgestaltung des Gehäuses ist das mindestens eine Befestigungselement integral mit dem Gehäuseteil ausgebildet. Es können so auf einfache Weise mehrere Befestigungselemente vorgesehen sein, die bedarfsweise entfernt werden.

Geeignete Befestigungselemente sind beispielsweise Sockel, insbesondere Rundsockel, Schraubdome und/oder eine Rastlaschen.

In einer weiteren vorteilhaften Ausgestaltung des Gehäuses umgibt die Vertiefung das Befestigungselement rechteckig. Eine derartige Vertiefung ist in seiner Form gut an Werkzeuge angepasst, die zum Herausbrechen der Befestigungselemente typischerweise eingesetzt werden, z.B. Flachzangen. Das Werkzeug kann bis auf die Grundfläche der Vertiefung abgesenkt werden, um das Befestigungselement zu greifen.

In alternativen Ausgestaltungen können auch andere Formen für die Vertiefung gewählt werden, z.B. die eines umlaufenden Grabens.

Vorteilhaft weist die Vertiefung gegenüber einer Oberfläche des Gehäuseteils eine Tiefe von 0,3 bis 0,8 mm auf. Diese Tiefe ist ausreichend für typische Bruchreste und gleichzeitig gering genug, um bei üblichen Wandstärken des Gehäuses dieses nicht mechanisch zu schwächen.

Die Erfindung wird nachfolgend anhand von Ausführungsbeispielen mit Hilfe von Figuren näher erläutert. Die Figuren zeigen:
- Fig.1: eine Aufsicht auf ein Gehäusegrundteil eines geöffneten Gehäuses;
- Fig. 2a, b: eine Schnittansicht durch ein erstes Befestigungselement vor (Fig. 2a) bzw. nach (Fig. 2b) einem Herausbrechen des Befestigungselements;
- Fig. 3a, b: eine Schnittansicht durch ein zweites Befestigungselement in gleicher Darstellung wie bei den Fig. 2a und 2b;
- Fig. 3c: eine alternative Ausgestaltung des Gehäuses im Bereich des zweiten Befestigungselements in gleicher Darstellung wie in Fig. 3a; und
- Fig. 4a, b: eine Schnittansicht durch ein drittes Befestigungselement in gleicher Darstellung wie bei den Fig. 2a und 2b.

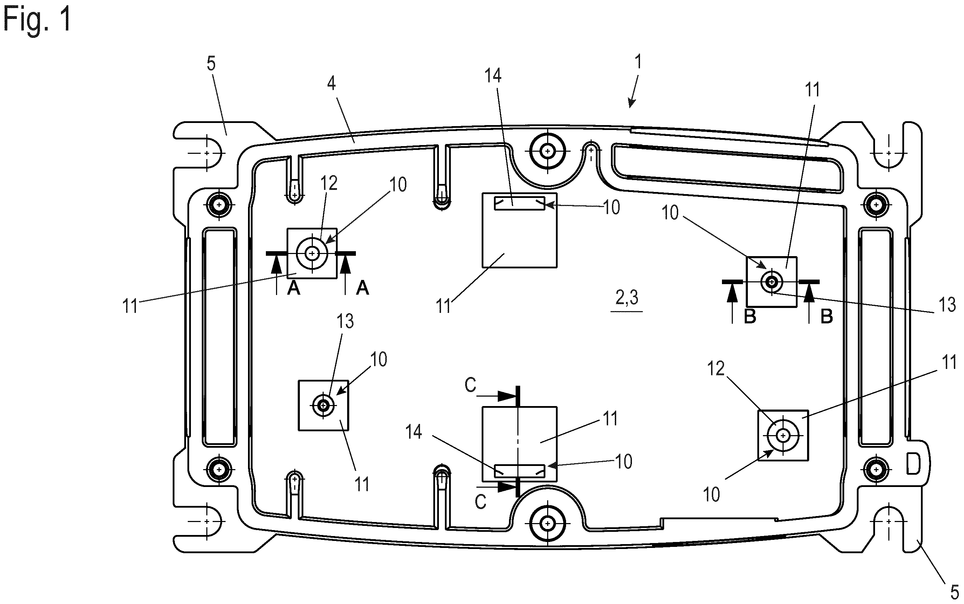

Fig. 1 zeigt eine Draufsicht auf ein Gehäusegrundteil 1 eines Ausführungsbeispiels eines Gehäuses. Das Gehäuse dient der Aufnahme von elektromechanischen, elektrischen und/oder elektronischen Komponenten, die in der Fig. 1 nicht dargestellt sind. Das Gehäuse wird nach dem Einsetzen und ggf. Anschließen der eingesetzten Komponenten durch einen hier nicht dargestellten Gehäusedeckel verschlossen.

Das Gehäusegrundteil 1 weist einen Gehäuseboden 2 auf, der eine im Wesentlichen ebene Oberfläche 3 hat. Seitlich ist das Gehäusegrundteil 1 durch Seitenwände begrenzt, die vom Boden 2 aus im Wesentlichen senkrecht hervorstehen, d.h. in der Fig. 1 aus der Blattebene heraus. Außen am Gehäuse sind Montageelemente 5 angeordnet, die einer Befestigung des Gehäuses auf einem Untergrund dienen. Die Form, Größe und Proportion des Gehäusegrundteils 1 und die Ausgestaltung der Montageelemente 5 sind dabei rein beispielhaft.

Auf dem Boden 2 sind verschiedene Befestigungselemente 10 angeordnet. Bevorzugt sind diese Befestigungselemente 10 integral mit dem Boden 2 und damit dem Gehäusegrundteil 1 ausgebildet. Beispielhaft sind bei dem Gehäuse der Fig. 1 drei verschiedene Befestigungselemente ausgebildet, von denen jeweils zwei vorhanden sind. Die Befestigungselemente 10 sind hier Rundsockel 12, Einschraubdome 13 und Rastlaschen 14. Die dargestellten Befestigungselemente 10 dienen beispielsweise der Aufnahme einer Leiterplatte. Diese wird parallel zum Boden 2 in das Gehäusegrundteil eingesetzt und liegt auf den Rundsockeln 12 und den Einschraubdomen 13 auf. Beim Einsetzten verrastet sie mit den Rastlaschen 14 und kann zudem mit jeweils einer Schraube, die in die Einschraubdome 13 eingeschraubt wird, befestigt werden.

Die Befestigungselemente 10 stehen dabei anmeldungsgemäß nicht unmittelbar auf der Ebene der Oberfläche 3 des Bodens 2, sondern sind in Vertiefungen 11 angeordnet, die die Befestigungselemente 10 jeweils umgeben. Wenn für eine bestimmte in das Gehäusegrundteil 1 eingesetzte Komponente eines oder mehrere der Befestigungselemente 10 nicht benötigt werden, können diese mit beispielsweise einer Greifzange gegriffen und durch Abknicken herausgebrochen werden. Die Vertiefungen 11 stellen dabei sicher, dass ev. noch verbleibende Bruchkanten nicht über die Ebene der Oberfläche 3 des Bodens 2 hervorstehen, so dass die Bruchkanten nicht stören, wenn Komponenten flächenbündig auf den Boden 2 aufgesetzt werden sollen.

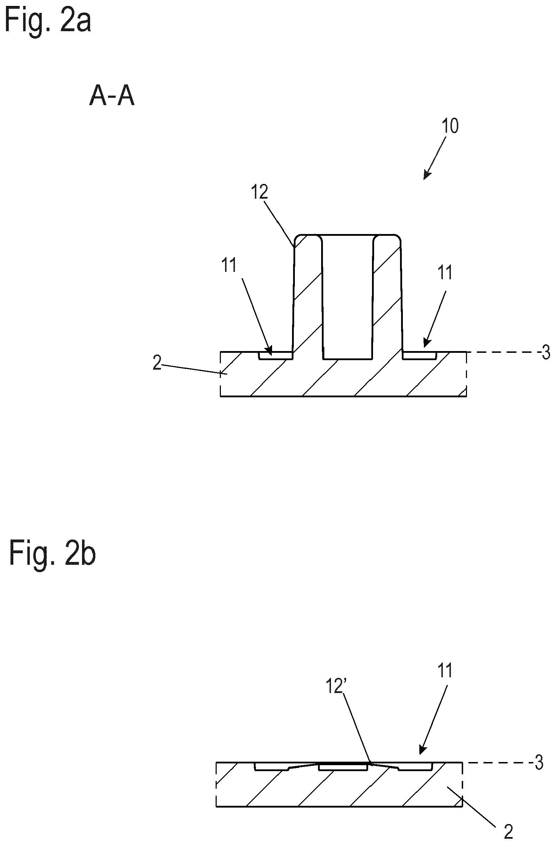

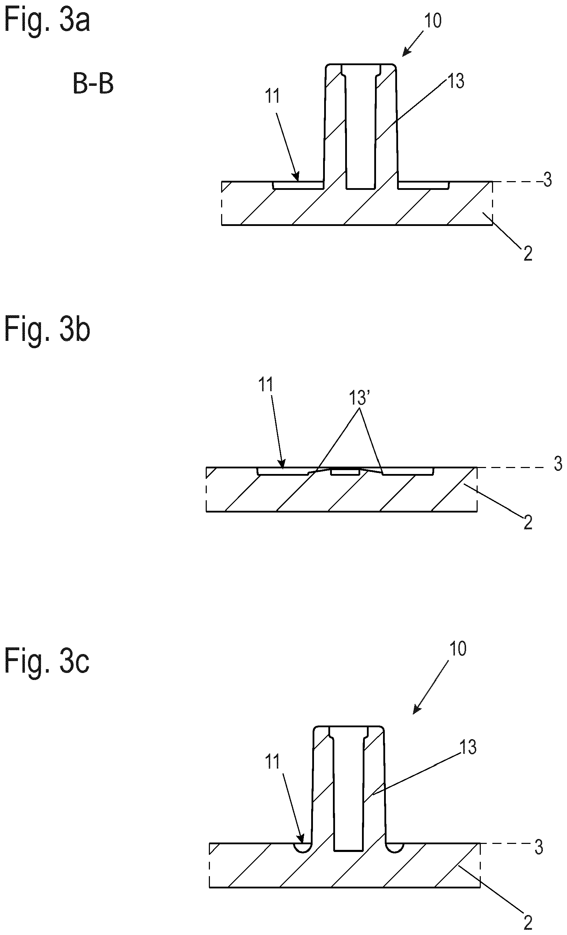

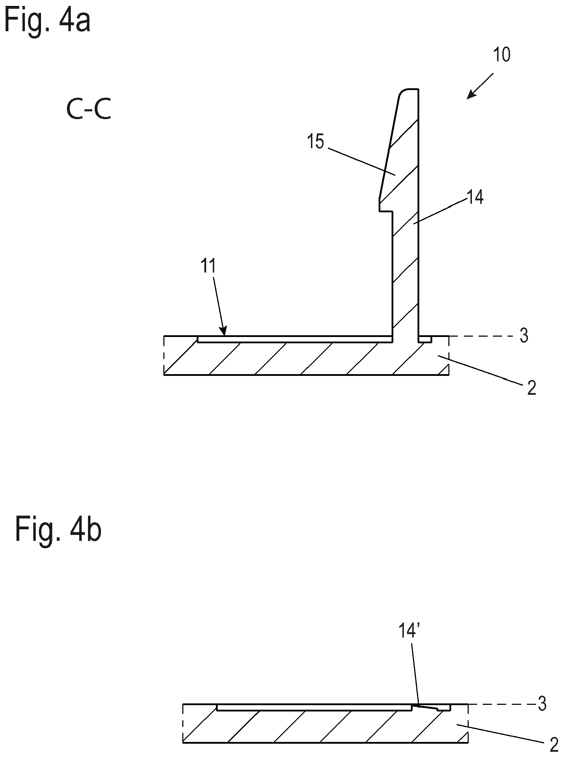

In den Fig. 2a, 3a und 4a sind die verschiedenen Befestigungselemente 10 jeweils in einer Schnittansicht detaillierter dargestellt. Die Fig. 2a zeigt einen der Rundsockel 12, die Fig. 3a einen der Einschraubdome 13 und die Fig. 4a eine der Rastlaschen 14.

In der Schnittzeichnung der Fig. 4a ist gut zu erkennen, dass die Rastlasche 14 im oberen Bereich einen hinterschnittenen Rasthaken 15 aufweist, mit dem sie eingesetzte Komponenten, beispielsweise die genannte eingesetzte Leiterplatte, an ihrer oberen Seite übergreift.

In den Fig. 2b, 3b und 4b ist jeweils die gleiche Schnittansicht wie in den Fig. 2a, 3a bzw. 4a gezeigt, nachdem das entsprechende Befestigungselement 10 herausgebrochen wurde. Es verbleiben Bruchreste 12', 13' und 14' von dem jeweiligen Befestigungselement 10. Wie die Fig. 2b, 3b und 4b zeigen, sind die verbleibenden Bruchreste 12', 13', 14' aufgrund der Vertiefungen 11, in denen die Befestigungselemente 10 angeordnet sind, zwar über die Grundfläche der Vertiefung 11 erhaben, sie ragen jedoch nicht über die Oberfläche 3 des Bodens 2 hinaus.

In allen Figuren außer der Fig. 3c sind die Vertiefungen 11 jeweils im Aufmaß rechteckig, konkret quadratisch um die das jeweilige Befestigungselement 10 angeordnet. Eine solche rechteckige bzw. quadratische Form ist insofern günstig, als dass Backen einer Greifzange, mit der das Befestigungselement 10 zum Herausbrechen gegriffen wird, bis auf den Grund der Vertiefung 11 hinab ragen können. Es sind jedoch grundsätzlich auch andere geometrische Formen für die Vertiefung 11 möglich. Für den Einschraubdom 13 ist in der Fig. 3c eine konzentrisch und ringförmig das Befestigungselement 10 umgebene grabenförmige Vertiefung 11 beispielhaft gezeigt.

Beim Ausführungsbeispiel der Fig. 1 sind alle von Vertiefung 11 umgebende Befestigungselemente 10 am Boden 2 des Gehäusegrundteils 1 angebracht. Es versteht sich, dass Befestigungselemente mit umgebender Vertiefung auch an anderen Gehäuseteilen oder Gehäuseflächen, beispielsweise an der Innenseite der Seitenwände 4 in ansonsten vergleichbarer Art vorgesehen sein können.

### Bezugszeichen

- 1: Gehäusegrundteil
- 2: Boden
- 3: Oberfläche des Bodens
- 4: Seitenwand
- 5: Montageelement

- 10: Befestigungselement
- 11: Vertiefung
- 12: Rundsockel
- 13: Einschraubdom
- 14: Rastlasche
- 15: Rasthaken
- 12'; 13'; 14': Bruchrest

## Patentansprüche

1. Gehäuse zur Aufnahme von mindestens einer elektromechanischen, elektrischen und/oder elektronischen Komponente, aufweisend mindestens ein an einem Gehäuseteil angeordnetes Befestigungselement (10) für die Komponente, **dadurch gekennzeichnet, dass** in dem Gehäuseteil eine Vertiefung (11) ausgebildet ist, in der das mindestens eine Befestigungselement (10) angeordnet ist.

2. Gehäuse nach Anspruch 1, bei dem das mindestens eine Befestigungselement (10) an einem Boden (2) eines Gehäusegrundteils (1) angeordnet ist.

3. Gehäuse nach Anspruch 1 oder 2, bei dem das mindestens eine Befestigungselement (10) integral mit dem Gehäuseteil ausgebildet ist.

4. Gehäuse nach einem der Ansprüche 1 bis 3, bei dem das mindestens eine Befestigungselement (10) ein Sockel, insbesondere ein Rundsockel (12), ein Schraubdom (13) und/oder eine Rastlasche (14) ist.

5. Gehäuse nach einem der Ansprüche 1 bis 4, bei dem die Vertiefung (11) das Befestigungselement (10) rechteckig umgibt.

6. Gehäuse nach einem der Ansprüche 1 bis 5, bei dem die Vertiefung (11) das Befestigungselement (10) umlaufend in Form eines Grabens umgibt.

7. Gehäuse nach einem der Ansprüche 1 bis 5, bei dem die Vertiefung (11) das Befestigungselement (10) umlaufend in Form eines Grabens umgibt.

8. Gehäuse nach einem der Ansprüche 1 bis 7, bei dem die Vertiefung (11) gegenüber einer Oberfläche des Gehäuseteils eine Tiefe von 0,3 bis 0,8 mm aufweist.
